# EUROPÄISCHE PATENTSCHRIFT

(11) **EP 1 145 022 B1**
(45) Veröffentlichungstag und Bekanntmachung des Hinweises auf die Patenterteilung: **12.04.2006**
(21) Anmeldenummer: 99929228.7
(22) Anmeldetag: 16.06.1999
(51) Int. Cl.: G01R 29/08

(54) **EINRICHTUNG ZUR MESSUNG DER SPEZIFISCHEN ABSORPTIONSRATE**
DEVICE FOR MEASURING THE SPECIFIC ABSORPTION RATE
DISPOSITIF DE MESURE DU TAUX D'ABSORPTION SPECIFIQUE

(30) Priorität: 14.07.1998 DE 19831386
(43) Veröffentlichungstag der Anmeldung: 17.10.2001
(73) Patentinhaber: Deutsche Telekom AG, 53113 Bonn (DE)
(72) Erfinder: HOMBACH, Volker, D-64807 Dieburg (DE); MARX, Bernd, D-64625 Bensheim (DE); LOPPNOW, Thomas, D-64354 Reinheim (DE)
(86) Internationale Anmeldenummer: PCT/EP1999/004144
(87) Internationale Veröffentlichungsnummer: WO 2000/004399

(56) Entgegenhaltungen:
- TAKEHIKO KOBAYASHI ET AL: "DRY PHANTOM COMPOSED OF CERAMICS AND ITS APPLICATION TO SAR ESTIMATION" IEEE TRANSACTIONS ON MICROWAVE THEORY AND TECHNIQUES, Bd. 41, Nr. 1, 1. Januar 1993 (1993-01-01), Seiten 136-140, XP000358558 ISSN: 0018-9480 in der Anmeldung erwähnt
- YU, ARONSSON, WU AND GANDHI: "AUTOMATED SAR MEASUREMENTS FOR COMPLIANCE TESTING OF CELLULAR TELEPHONES" IEEEANTENNAS AND PROPAGATION SOCIETY INTERNATIONAL SYMPOSIUM, [Online] Bd. 4, 21. - 26. Juni 1998, Seiten 1980-1983, XP002118064 ATLANTA ISBN: 0-7803-4478-2
- BALZANO Q ET AL: "ELECTROMAGNETIC ENERGY EXPOSURE OF SIMULATED USERS OF PORTABLE CELLULAR TELEPHONES" IEEE TRANSACTIONS ON VEHICULAR TECHNOLOGY, Bd. 44, Nr. 3, 1. August 1995 (1995-08-01), Seiten 390-403, XP000526029 ISSN: 0018-9545 in der Anmeldung erwähnt
- HOMBACH, MEIER, BURKHARDT, KUHN AND KUSTER: "THE DEPENDENCE OF EM ENERGY ABSORPTION UPON HUMAN HEADMODELING AT 900 MHZ" IEEE TRANSACTIONS ON MICROWAVE THEORY AND TECHNIQUES, Bd. 44, Nr. 10, Oktober 1996 (1996-10), Seiten 1865-1873, XP002118065
- PATENT ABSTRACTS OF JAPAN vol. 199, no. 507, 31. August 1995 (1995-08-31) & JP 07 092110 A (NEC), 7. April 1995 (1995-04-07)

## Beschreibung

### Anwendungsgebiet

In der modernen Industriegesellschaft wird eine Vielzahl von Geräten benutzt, die elektromagnetische Felder erzeugen. In nationalen und internationalen Normen bzw. Gesetzen sind Grenzwerte für derartige Felder festgelegt worden, die zum Schutz der Gesundheit von Personen nicht überschritten werden dürfen. Als Basismeßgröße zur Quantifizierung der elektromagnetischen Exposition im Hochfrequenzfeld wird dabei die Spezifische Absorptionsrate SAR benutzt, die die im Gewebe absorbierte Leistung pro Masseneinheit angibt. Bei Nahfeldexposition, wie sie z. B. bei der Nutzung von Handfunktelefonen auftritt, beziehen sich die SAR-Grenzwerte auf die maximale, im menschlichen Körper auftretende, über 1 g oder 10 g Gewebemasse gemittelte Absorption. Die SAR-Verteilung in einer Person kann über numerische Simulationsrechnungen oder über Messungen mit elektrischen Feldsonden in Phantommodellen bestimmt werden. Der Hauptvorteil der Messung gegenüber der Rechnung liegt in der einfachen und zuverlässigen Ermittelbarkeit von Unterschieden und Streuungen zwischen einzelnen elektromagnetische Felder erzeugenden Geräten.

### Stand der Technik

Da die Messung von SAR-Werten nicht direkt in einem lebenden Organismus durchgeführt werden kann, verwendet man Phantommodelle des menschlichen Körpers oder von Körperteilen, wie z. B. dem Kopf, die möglichst gut die realen Verhältnisse wiederspiegeln. Ein heute vielfach eingesetzter Meßplatz zur Ermittlung von SAR-Werten, die von Handfunktelefonen in einem Kopf erzeugt werden, ist beschrieben in "Q. Balzano, O. Garay and T. J. Manning: Electromagnetic energy exposure of simulated users of portable cellular telephones, IEEE Transactions on Vehicular Technology, Vol. 44, No. 3, Aug. 1995, pp. 390 -403." Hierbei wird das zu untersuchende Handfunktelefon außen an einem der menschlichen Kopfform nachgebildeten Phantommodell befestigt. Das Phantommodell besteht aus einer dünnen Kunststoffschale, die mit einer gewebesimulierenden Flüssigkeit gefüllt ist. In dieser Flüssigkeit wird eine elektrische Feldsonde mit Hilfe eines Industrieroboters, der von einem Computer gesteuert wird, bewegt. Der Computer zeichnet dabei die elektrischen Feldstärke- bzw. SAR-Werte über einem dreidimensionalen Gitternetz in dem Phantommodell auf und berechnet aus den Einzelwerten die grenzwertrelevanten über 1 g oder 10 g Gewebemasse gemittelten SAR-Werte. Neben den nicht zu bezweifelnden Vorteilen weist ein derartiger Meßplatz für systematische Reihensowie entwicklungsbegleitende Untersuchungen verschiedene Nachteile auf:
a) Die Verwendung eines Industrieroboters einschließlich dreidimensionaler Steuerung verursacht hohe Investitions- und Betriebskosten.
b) Der Zeitaufwand für den Meßdurchgang mit einer einzelnen Position des Handfunktelefons beträgt 30 Minuten oder mehr. Um die ungünstigste Position mit dem höchsten SAR-Wert herauszufinden, sind in der Regel mehrere Meßdurchgänge erforderlich.
c) Um die Sonde im Phantominnern bewegen zu können, muß dieses mit einer Flüssigkeit gefüllt sein. Da die Flüssigkeit mit der Zeit verdunstet und ihre elektrischen Eigenschaften ändert, müssen die Flüssigkeitsparameter ständig überwacht werden.

### Aufgabenstellung und Lösung

Der Erfindung liegt das Ziel zugrunde die Nachteile des bekannten Meßplatzes bei der Qualifizierung von elektromagnetischen Hochfrequenzfeldern erzeugenden Geräten zu vermeiden:
a) Die elektrische Feldsonde wird bei der erfindungsgemäßen Meßeinrichtung nicht innerhalb des Phantommodells bewegt, sondern befindet sich an einem definierten, festen Ort, vorzugsweise 5 bis 9 mm unter der Oberfläche. Damit entfällt der Aufwand für die mechanische Bewegung, deren Steuerung und Auswertung. Stattdessen wird das zu untersuchende Gerät (z. B. ein Handfunktelefon) von Hand oder mit einem einfachen Verschiebemechanismus außen an der Phantomoberfläche vorbei bewegt. Dabei kann auch der Einfluß der Hand mit erfaßt werden.
b) Zur Einstellung von z. B. in einer Norm vorgegebenen Positionen des untersuchten Gerätes können einfache mechanische Hilfsvorrichtungen aus nichtleitendem Kunststoff verwendet werden. Durch gezieltes Ausprobieren ist es mit geringem Aufwand in kürzester Zeit möglich, die Position zu finden, bei der die angezeigte Spezifische Absorptionsrate maximal wird.
c) Die vorliegende Erfindung verwendet ein Phantommodell aus einem festen Werkstoff, der z. B. aus einer Kombination von Kunstharz, Keramikpulver und Graphitpulver besteht. In "T. Kobayashi u. a.: Dry phantom composed of ceramics and ist application to SAR estimation, IEEE Transactions on Microwave Theory and Techniques, Vol. 41, No. 1, Jan. 1993, pp. 136 -140" wird gezeigt, daß auch mit festen Werkstoffen die elektrischen Eigenschaften von menschlichen Geweben nachgebildet werden können. Wie noch erläutert wird, ist für die Meßgenauigkeit der erfindungsgemäßen Einrichtung die exakte Einhaltung der Gewebeparameter nur von untergeordneter Bedeutung. Das feste Phantommodell ist ungiftig, einfach zu handhaben und verändert seine Eigenschaften nicht mit der Zeit.
d) Da die Sonde sich in dem verlustbehafteten Phantom an einem festen Ort befindet, ist der Aufwand für die Ableitung des detektierten Signales wesentlich geringer als bei den hochkomplizierten Sonden, die für Flüssigphantome eingesetzt werden müssen. Das Sondensignal braucht nur mit einer einfachen elektronischen Schaltung verstärkt und einem den zeitlichen Mittelwert bildenden Anzeigeinstrument zugeführt zu werden.

### Beschreibung der Erfindung

Der Aufbau einer erfindungsgemäßen Meßeinrichtung wird anhand verschiedener Skizzen erläutert.
**Fig. 1** ist eine Querschnittsskizze einer erfindungsgemäßen Meßeinrichtung.
**Fig. 2** gibt ein weiteres Ausführungsbeispiel mit einem Halbkugelphantom wieder.
**Fig. 3** dient zur Erläuterung der Eichung einer erfindungsgemäßen Meßeinrichtung.
**Fig. 4** veranschaulicht das Beispiel einer Hilfsvorrichtung zur definierten Positionierung von Handfunktelefonen.

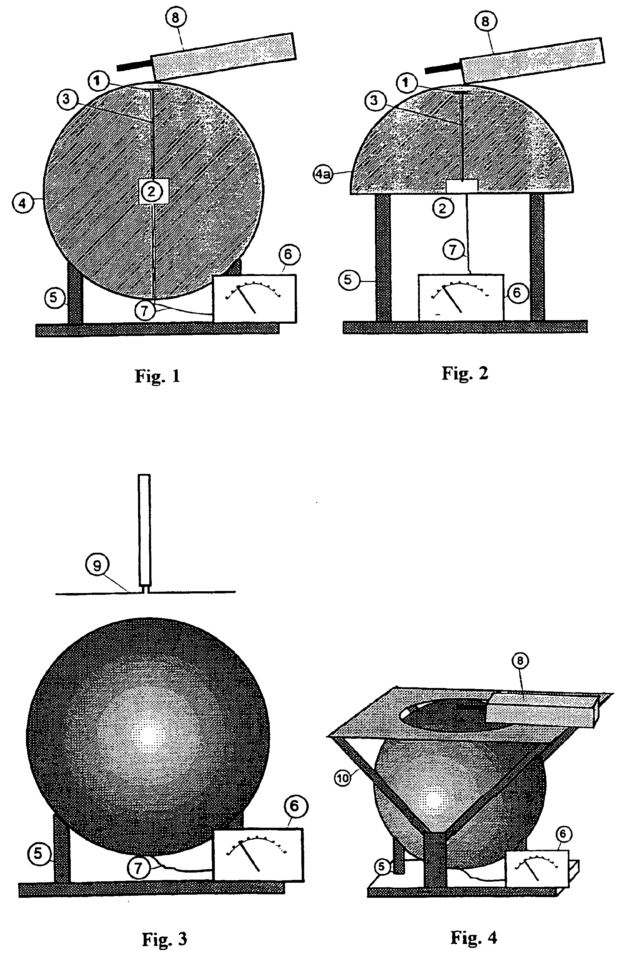

Die erfindungsgemäße Meßeinrichtung besteht, wie in **Fig. 1** dargestellt, aus einer Kugel 4 mit einem Durchmesser von 180 bis 200 mm. Der Werkstoff der Kugel ist fest und besitzt in etwa die mittleren elektrischen Eigenschaften von menschlichem Gewebe (z. B. bei 900 MHz die Werte: relative Dielektrizitätszahl = 42, spezifische Leitfähigkeit = 0.9 S/m). Die Kugel wird von einem Ständer 5 aus nicht leitendem Material gehalten. Zur Messung des über 1 g gemittelten SAR-Wertes befindet sich eine Dipolsonde 1 mit einer Gesamtlänge von ca. 8 mm in einem Abstand von 5 mm unter der Kugeloberfläche. Zur Messung des über 10 g gemittelten SAR-Wertes muß der Abstand der Sonde zur Kugeloberfläche etwa 9 mm betragen. Das von der Dipolsonde empfangene Hochfrequenzsignal wird mit einer Detektordiode gleichgerichtet und über einen Tiefpaß und eine hochohmige Leitung 3 zur Auswerteelektronik 2 in Kugelmitte geleitet. Die Auswerteelektronik liefert eine dem gemessenen lokalen SAR-Wert proportionale Gleichspannung, die über eine Leitung 7 dem analogen oder digitalen Anzeigeinstrument 6 zugeführt wird. Die Spannungsversorgung der Auswerteelektronik kann entweder in der Kugel oder außerhalb untergebracht werden. Das zu untersuchende Gerät 8, das z. B. ein Handfunktelefon ist, wird an der Oberfläche der Kugel vorbeigeführt. Am Anzeigeinstrument kann dabei unmittelbar der über 1 g oder 10 g gemittelte SAR-Wert abgelesen werden. So kann unter anderem recht einfach die Stellung mit maximaler Anzeige gefunden werden.

Da in der verlustbehafteten Phantomkugel bei der hier interessierenden Expositionssituation die Polarisation der elektrischen Feldstärke in Oberflächennähe nahezu parallel zur Oberfläche liegt, reicht es aus, *eine* Dipolsonde mit entsprechend angeordneten Dipolarmen einzusetzen. Durch Drehen des zu testenden Gerätes ist dann zunächst die Polarisationsausrichtung mit maximalem Anzeigewert zu ermitteln. Um von der Polarisationsausrichtung der Geräteantenne unabhängig zu sein, können auch zwei senkrecht zueinander und jeweils parallel zur Oberfläche liegende Dipole eingebaut werden, deren Signale in der Auswerteelektronik addiert werden.

Aufgrund der hohen Abschirm- und Absorptionswirkung des Phantomwerkstoffes, kann die Meßeinrichtung auch, wie in **Fig. 2** skizziert, nur aus einer Halbkugel 4a aufgebaut werden. Für normbezogene Aussagen über den Absolutwert der Spezifischen Absorptionsrate muß die Meßeinrichtung vor der Benutzung geeicht werden. **Fig. 3** zeigt eine einfache aber zuverlässige Eichmöglichkeit. In einem Abstand von 10 bis 50 mm über der Kugel wird ein Sendedipol 9 mit der Gesamtlänge einer halben Wellenlänge angebracht und mit einer definierten Leitung gespeist. Der dabei angezeigte Meßwert wird mit dem Meßwert verglichen, der aus einer Simulationsrechnung mit der gleichen geometrischen Anordnung und der gleichen Sendeleistung ermittelt wurde. Da Simulationsrechnungen mit der Methode der Finiten Diffrenzen im Zeitbereich, der Methode der Finiten Elemente oder der Momentenmethode für so einfache Geometrien verifizierbare und zuverlässige Ergebnisse liefern, können bei dieser Eichung der Gesamtanordnung verschiedene Fehlereinflüsse, die aus Ungenauigkeiten bei der Phantomkugelherstellung (z. B. bezüglich der elektrischen Materialparameter und der Sondenpositionierung) resultieren, kompensiert werden. Es ist sinnvoll, die notwendigen Eichfaktoren direkt in die Auswerteelektronik zu übernehmen, um eine einfach abzulesende Instrumentenanzeige zu erhalten.

Für spezielle normgerechte Messungen ist eine definierte Positionierung des zu beurteilenden Handfunktelfons notwendig. Um eine derartige Positionierung reproduzierbar einzustellen, kann eine Hilfsvorrichtung 10 aus nichtleitendem Kunststoff beispielsweise nach **Fig. 4** angebracht werden. Die Hilfseinrichtung muß mit entsprechenden Markierungen versehen und in mehreren Achsen bewegbar sein.

Was die Vergleichgbarkeit der mit der erfindungsgemäßen Meßeinrichtung gefundenen SAR-Werte mit den tatsächlich in einem Menschen auftretenden SAR-Werte betrifft, sind folgende Überlegungen zu beachten:
- Wie ausführliche Simulationsuntersuchungen zeigen, weisen die von dem gleichen Handfunktelefon in verschiedenen menschlichen Köpfen erzeugten SAR-Werte eine gewisse Streubreite auf, die auf die individuellen äußeren Kopfformen, unterschiedliche inhomogene Gewebeverteilungen und voneinander abweichende Gewebeparamter zurückzuführen sind. Es gibt also nicht *den einheitlichen* SAR-Wert, der einem Handfunktelefon zugeordnet werden kann.
- Sowohl Simulationsrechnungen als auch Messungen belegen, daß bei geeigneter Wahl der Dielektrizitätszahl und der Leitfähigkeit eines homogenen Kopfmodelles die über 1g oder 10 g gemittelten SAR-Werte, die von einem Handfunktelefon im Nahfeld erzeugt werden, höher oder gleich den SAR-Werten eines inhomogenen Kopfmodells sind. Die mit homogenen Modellen gefundenen SAR-Werte liegen bei Orientierung an den Personenschutzgrenzwerten also *auf der sicheren Seite.*
- Bei homogenen Phantommodellen ist die elektromagnetische Absorption von der Oberflächenkontur bzw. vom Krümmungsradius abhängig. Bei Nahfeldexposition steigt der maximale lokale, über 1 g oder 10 g gemittelte SAR-Wert für Krümmungsradien über einer Viertel Wellenlänge nur noch sehr wenig an. Eine Kugel mit einem Durchmesser von 180 bis 200 mm beschreibt daher sehr gut die relevanten Krümmungsradien von menschlichen Köpfen und liefert eher zu hohe als zu niedrige SAR-Werte.

## Patentansprüche

1. Einrichtung zur Messung der spezifischen Absorptionsrate, die von einem elektromagnetische Felder erzeugenden Gerät, vorzugsweise von einem Handfunktelefon, in einem Kopfphantom hervorgerufen wird, **dadurch gekennzeichnet, dass** sie als homogenes kugelförmiges Phantommodell, Kugel (4), mit einem Durchmesser von vorzugsweise 180 bis 200 mm ausgebildet ist, und aus einem festem Werkstoff, beispielsweise einer Kombination von Kunstharz, Keramikpulver und Graphitpulver mit den elektrischen Eigenschaften gemittelten menschlichen Gewebes, insbesondere einer relativen Dielektrizitätszahl = 42 und einer spezifischen Leitfähigkeit = 0,9S/m bei 900 MHz , besteht,
dass in einem Bereich von 5 - 10 mm unter der Kugeloberfläche eine als elektrische Feldsonde ausgebildete, ca. 8 mm lange Dipolsonde (1) eingebettet ist, die über eine hochohmige Leitung (3) mit einer in der Kugelmitte angeordneten Auswerteelektronik (2) verbunden ist, dass die Auswerteelektronik (2) über eine Leitung (7) mit einem analogen/digitalen Anzeigeinstrument (6) zur Ablesung der spezifischen Absorptionsrate SAR verbunden ist, und
dass für normbezogene Aussagen über den Absolutwert der spezifischen Absorptionsrate in einem Abstand von 10 bis 50mm über dem Phantommodell, Kugel (4), ein mit einer definierten Leistung gespeister Sendedipol (9) mit der Gesamtlänge einer halben Wellenlänge angeordnet wird, wobei der dabei angezeigte Messwert mit dem Messwert verglichen wird, der aus einer Simulationsrechnung mit der gleichen geometrischen Anordnung und der gleichen Sendeleistung ermittelt wurde.

2. Einrichtung zur Messung der Spezifischen Absorptionsrate nach Anspruch 1, **dadurch gekennzeichnet, daß** das Pantommodell aus einem Kugelabschnitt, wie z. B. einer Halbkugel (4a) besteht.

3. Einrichtung zur Messung der Spezifischen Absorptionsrate nach Anspruch 1, **dadurch gekennzeichnet, daß** zur definierten reproduzierbaren Positionierung des zu untersuchenden Gerätes (8) eine in mehreren Achsen bewegbare Hilfsvorrichtung (10) von außen an das Phantommodell angesetzt ist, die aus nichtleitendem Kunststoff besteht und entsprechende Markierungen aufweist.

4. Einrichtung zur Messung der Spezifischen Absorptionsrate nach Anspruch 1, **dadurch gekennzeichnet, daß** die elektrische Feldsonde aus einem elektrischen Dipol (1) oder aus zwei orthogonal zueinander stehenden Dipolen besteht.

5. Einrichtung zur Messung der spezifischen Absorptionsrate nach Anspruch 1, **dadurch gekennzeichnet, dass** das Phantommodell, Kugel (4), von einem Ständer (5) aus nicht leitendem Material gehalten wird.

## Claims

1. Apparatus for measuring the specific absorption rate induced in a phantom head by an electromagnetic-field-producing device, preferably by a hand-held radio telephone,
**characterized in that**
said apparatus is designed as a homogeneous spherical phantom model, sphere (4), having a diameter of preferably 180 to 200 mm, and is made of a solid material, for example a combination of synthetic resin, ceramic powder and graphite powder, with the electrical characteristics of average human tissue, in particular a relative dielectric constant = 42 and a specific conductivity = 0.9 S/m at 900 MHz,
**in that**, embedded in a region of 5 - 10 mm beneath the surface of the sphere is a dipole probe (1) approximately 8 mm in length designed as an electric field probe, said probe being connected by a high-resistance line (3) to an analysis electronics unit (2) arranged in the center of the sphere, **in that** the analysis electronics unit (2) is connected by a line (7) to an analog/digital display instrument (6) for readout of the specific absorption rate SAR, and
**in that**, for standards-related determinations of the absolute value of the specific absorption rate, there is arranged at a distance of 10 to 50 mm above the phantom model, sphere (4), a transmitting dipole (9) having an overall length of one-half wavelength and being supplied with a defined power, wherein the measured value indicated in this process is compared to the measured value that was determined from a simulation calculation using the same geometric arrangement and the same transmitted power.

2. Apparatus for measuring the specific absorption rate according to claim 1, **characterized in that** the phantom model consists of a section of a sphere, such as a hemisphere (4a), for example.

3. Apparatus for measuring the specific absorption rate according to claim 1, **characterized in that** for defined, reproducible positioning of the device (8) under investigation, an auxiliary contrivance (10) that is movable in multiple axes is placed on the phantom model from outside, said contrivance being made of nonconductive plastic and having appropriate markings.

4. Apparatus for measuring the specific absorption rate according to claim 1, **characterized in that** the electric field probe consists of one electric dipole (1) or of two mutually perpendicular dipoles.

5. Apparatus for measuring the specific absorption rate according to claim 1, **characterized in that** the phantom model, sphere (4), is held by a stand (5) made of nonconductive material.

## Revendications

1. Equipement de mesure du taux d'absorption spécifique provenant, dans une tête fantôme, d'un appareil générant des champs électromagnétiques, notamment d'un portable, **caractérisé en ce qu'**il se présente sous la forme d'un mannequin fantôme homogène sphérique, sphère (4), d'un diamètre de préférence compris entre 180 et 200 mm, et est constitué d'un matériau solide, comme par exemple une combinaison de résine synthétique, de poudre céramique et de poudre de graphite possédant les propriétés électriques d'un tissu humain moyen, en particulier une permittivité relative égale à 42 et une conductivité spécifique de 0,9 S/m à 900 MHz,
**en ce qu'**une sonde bipolaire (1) d'environ 8 mm de longueur est insérée comme sonde de champ électrique dans une zone comprise entre 5 et 10 mm sous la surface de la sphère, cette sonde étant reliée par un circuit à haute résistance (3) à un système électronique d'évaluation (2) situé au centre de la sphère et le système électronique d'évaluation (2) étant relié par un circuit (7) à un instrument indicateur analogique/numérique (6) qui mesure le taux d'absorption spécifique TAS et
**en ce que**, pour obtenir des indications normalisées sur la valeur absolue du taux d'absorption spécifique, un dipôle d'émission (9) alimenté d'une puissance définie et dont la longueur totale est égale à une demie longueur d'onde est disposé à un intervalle de 10 à 50 mm du mannequin fantôme, sphère (4), la valeur de mesure indiquée étant comparée à la valeur de mesure obtenue d'un calcul de simulation avec la même disposition géométrique et la même puissance d'émission.

2. Equipement de mesure du taux d'absorption spécifique selon la revendication 1, **caractérisé en ce que** le mannequin fantôme est constitué d'une portion de sphère, par exemple d'une demi-sphère (4a).

3. Equipement de mesure du taux d'absorption spécifique selon la revendication 1, **caractérisé en ce que**, pour obtenir un positionnement défini et reproductible de l'appareil à examiner (8), un dispositif auxiliaire (10) en matière plastique non conductrice articulé sur plusieurs axes et présentant des marquages appropriés est appliqué depuis l'extérieur sur le mannequin fantôme.

4. Equipement de mesure du taux d'absorption spécifique selon la revendication 1, **caractérisé en ce que** la sonde de champ électrique est constituée d'un dipôle électrique (1) ou de deux dipôles disposés perpendiculairement l'un par rapport à l'autre.

5. Equipement de mesure du taux d'absorption spécifique selon la revendication 1, **caractérisé en ce que** le mannequin fantôme, sphère (4), est soutenu par un support (5) d'un matériau non conducteur.
